# FASCICULE DE BREVET EUROPEEN

(11) **EP 2 870 605 B1**
(45) Date de publication et mention de la délivrance du brevet: **20.07.2016**
(21) Numéro de dépôt: 13744656.3
(22) Date de dépôt: 28.06.2013
(51) Int. Cl.: G11C 16/22, G11C 16/34

(54) **PROCÉDÉ D'EFFACEMENT OU DE PROGRAMMATION D'UNE MÉMOIRE FACTICE PROTÉGÉ CONTRE LA DÉTECTION**
DUMMY-SPEICHER-LÖSCH- ODER PROGRAMMIERVERFAHREN MIT SCHUTZ GEGEN DETEKTION
DUMMY MEMORY ERASING OR PROGRAMMING METHOD HAVING PROTECTION AGAINST DETECTION

(30) Priorité: 09.07.2012 FR 1201940
(43) Date de publication de la demande: 13.05.2015
(73) Titulaire: Inside Secure, 13590 Meyreuil (FR)
(72) Inventeur: MERANDAT, Marc, F-13590 Meyreuil (FR)
(74) Mandataire: Marchand, André
(86) Numéro de dépôt international: PCT/FR2013/051519
(87) Numéro de publication internationale: WO 2014/009627

(56) Documents cités:
- US-A1- 2002 101 763
- US-A1- 2002 174 310
- US-A1- 2008 117 674

## Description

La présente invention concerne un procédé d'effacement ou de programmation de cellules mémoire d'une mémoire non volatile, ainsi qu'une telle mémoire non volatile.

Les mémoires à semi-conducteurs non volatiles, telles que les mémoires EEPROM et Flash, comprennent généralement un plan de cellules mémoire effaçables et programmables électriquement. De telles cellules mémoire comprennent généralement au moins un transistor à grille flottante FGT. Un transistor à grille flottante comprend généralement des régions de source et de drain, une région de canal s'étendant entre les régions de source et de drain, une grille de commande s'étendant au-dessus de la région de canal, et une grille flottante s'étendant entre la grille de commande et la région de canal.

Un transistor flottant est programmé en appliquant des impulsions de tension (« impulsions de programmation ») sur sa région de source ou de drain, ou par l'intermédiaire de sa région de substrat, pour injecter des charges électriques dans la grille flottante. Inversement, il est effacé en appliquant des impulsions de tension (« impulsions d'effacement ») sur sa grille de commande ou par l'intermédiaire de la région de substrat, pour extraire des charges électriques de la grille flottante. La quantité de charges électriques dans la grille flottante définit la tension de seuil du transistor, qui correspond à la valeur d'une donnée stockée dans la cellule mémoire.

De telles cellules mémoire ont une durée de vie effective limitée, également connue sous le nom d'endurance. Le nombre de cycles d'effacement et de programmation qu'une telle cellule peut supporter avant de se dégrader est limité, compte tenu du transfert répété de charges vers et en provenance de la grille flottante. De ce fait, le nombre d'impulsions de programmation ou d'effacement devant être appliquées à une cellule mémoire pour réaliser le processus de programmation ou d'effacement peut augmenter dans le temps, avec le vieillissement de la cellule.

Par conséquent, dans certaines mémoires, le nombre d'impulsions d'effacement ou de programmation appliqué à une cellule mémoire est surveillé par un circuit de commande, qui vérifie l'état de la cellule mémoire pendant qu'elle est en cours d'effacement ou de programmation. Le nombre d'impulsions d'effacement ou de programmation est ajusté en temps réel jusqu'à ce que les cellules aient atteint l'état effacé ou programmé souhaité, ou jusqu'à ce qu'un nombre maximum autorisé d'impulsions soit atteint. Ainsi, la dispersion des tensions de seuil des différentes cellules mémoire est réduite à l'intérieur de la totalité du plan mémoire.

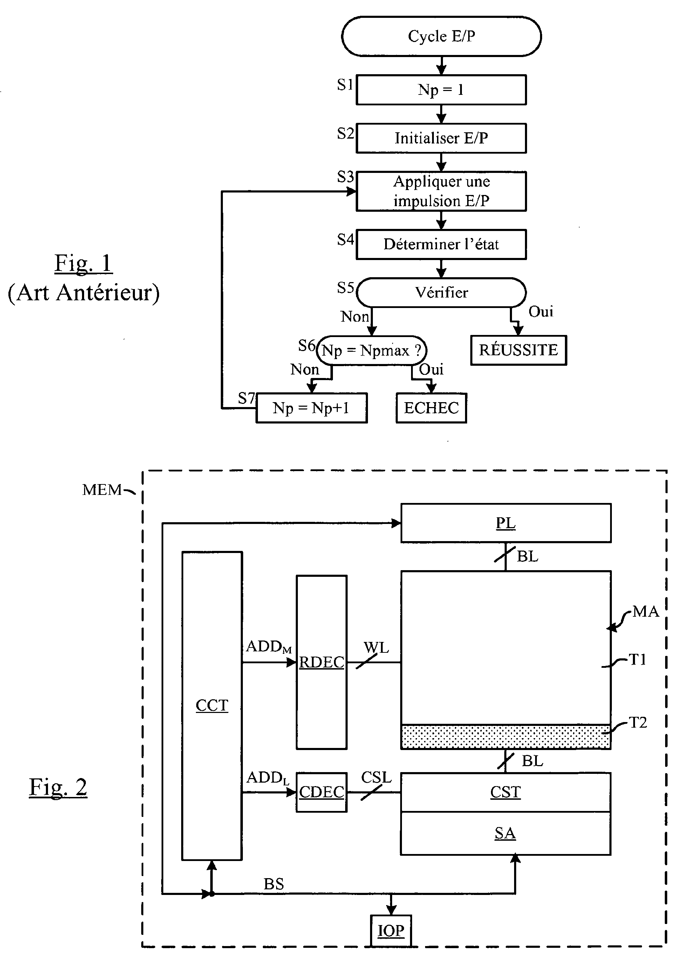

La Figure 1 est un organigramme d'un cycle conventionnel de réalisation de cycles d'effacement ou de programmation sur des cellules mémoire, par exemple du type décrit dans le brevet US 7,983,078.

Lors d'une étape S1, une variable Np est mise à une valeur initiale, par exemple 1. Lors d'une étape S2, l'opération d'effacement ou de programmation est initialisée. Lors d'une étape S3, une impulsion d'effacement ou de programmation est appliquée à des cellules mémoire désignées. Lors d'une étape S4, les états des cellules mémoire sont déterminés. Lors d'une étape S5, les états des cellules mémoire sont vérifiés afin de contrôler s'ils correspondent à l'état souhaité. Si la réponse est oui, le circuit de commande interrompt le cycle avec le statut « réussite ». Si l'état souhaité n'est pas encore atteint, lors d'une étape S6, on vérifie si Np est égal à un nombre maximum autorisé d'impulsions Npmax. Si la réponse est oui, le cycle est interrompu avec le statut « échec ». Si Np est inférieur à Npmax, Np est augmenté de un lors d'une étape S7, et le cycle revient à l'étape S3. Des autres méthodes conventionelles sont décrites dans les brevets US2002/0101763 et US 2002/0174310

Dans certaines applications telles que les calculs cryptographiques, il est parfois souhaité de masquer certaines opérations d'écriture lorsque des données sensibles sont en jeu. Ce masquage peut inclure l'écriture de fausses données dans certaines cellules mémoire, afin d'induire en erreur un tiers observant le comportement du circuit de la mémoire. L'écriture de fausses données dans les cellules mémoire est réalisée comme illustré en figure 1, à la seule différence que la valeur réelle des données à la fin du cycle d'effacement ou de programmation n'a pas d'importance.

Par souci de simplicité, les cycles d'effacement ou de programmation relatifs à de fausses données seront dénommés ci-après opérations « factices », et les cellules mémoire destinées à recevoir ces fausses données seront désignées cellules « factices ».

En général, bien que les cycles factices se produisent généralement moins fréquemment que les cycles de données régulières, une portion plus faible de l'espace mémoire disponible est dédiée aux opérations factices. De ce fait, les cellules mémoire dédiées aux opérations factices sont soumises à plus de cycles d'effacement et/ou de programmation que les cellules mémoire dédiées à des opérations régulières. De ce fait, les cellules mémoire factices vieillissent plus rapidement que les cellules mémoire régulières, et, au fil du temps, les opérations d'effacement ou de programmation factices peuvent être distinguées des opérations d'effacement ou de programmation régulières en ce qu'elles impliquent plus d'impulsions d'effacement ou de programmation.

une telle mémoire avec des cellules "factices" est décrit dans le brevet US 2008/0117674.

La présente invention comprend l'observation selon laquelle, en comptant le nombre d'impulsions nécessaires à une opération d'effacement ou de programmation, un attaquant peut être en mesure de distinguer une opération d'effacement ou de programmation factice d'une opération d'effacement ou de programmation régulière.

Il peut par conséquent être souhaitable de fournir un procédé de réalisation d'un cycle d'effacement ou de programmation réduisant un tel risque de sécurité.

Des modes de réalisation de l'invention concernent un procédé de programmation ou d'effacement de cellules mémoire d'une mémoire non volatile comprenant un premier cycle d'effacement ou de programmation de premières cellules mémoire, comprenant les étapes consistant à : i) appliquer au moins une impulsion d'effacement ou de programmation aux cellules mémoire, ii) déterminer l'état, effacé ou programmé, des cellules mémoire, et iii) répéter les étapes i) et ii) si les cellules mémoire ne sont pas dans l'état souhaité. Le procédé comprend en outre un second cycle d'effacement ou de programmation de secondes cellules mémoire, comprenant l'application d'un nombre prédéterminé d'impulsions d'effacement ou de programmation aux secondes cellules mémoire.

Selon un mode de réalisation, le nombre prédéterminé d'impulsions d'effacement ou de programmation est fonction d'un premier nombre d'impulsions appliquées à des premières cellules mémoire pendant au moins un premier cycle d'effacement ou de programmation de premières cellules mémoire.

Selon un mode de réalisation, le second cycle comprend les étapes consistant à : iv) appliquer au moins une impulsion d'effacement ou de programmation aux cellules mémoire, v) déterminer l'état, effacé ou programmé, des cellules mémoire, et vi) répéter les étapes iv) et v) jusqu'à ce que le nombre prédéterminé d'impulsions d'effacement ou de programmation soit appliqué aux secondes cellules mémoire.

Selon un mode de réalisation, le procédé comprend une étape consistant à vérifier si le cycle d'effacement ou de programmation est réalisé sur la première ou la seconde cellule mémoire.

Selon un mode de réalisation, le premier cycle d'effacement ou de programmation comprend une étape de stockage du nombre d'impulsions appliquées aux premières cellules mémoire pour les mettre dans l'état souhaité.

Selon un mode de réalisation, le nombre prédéterminé d'impulsions d'effacement ou de programmation est déterminé selon au moins l'une des méthodes suivantes : le nombre prédéterminé d'impulsions d'effacement ou de programmation est fonction du nombre d'impulsions d'effacement ou de programmation appliquées aux premières cellules mémoire pendant un premier cycle d'effacement ou de programmation de premières cellules mémoire ; le nombre prédéterminé d'impulsions d'effacement ou de programmation est fonction d'une valeur moyenne de nombres d'impulsions d'effacement ou de programmation appliquées aux premières cellules mémoire pendant une pluralité de premiers cycles d'effacement ou de programmation de premières cellules mémoire ; le nombre prédéterminé d'impulsions d'effacement ou de programmation est fonction d'une valeur maximale de nombres d'impulsions d'effacement ou de programmation appliquées aux premières cellules mémoire pendant une pluralité de premiers cycles d'effacement ou de programmation de premières cellules mémoire.

Selon un mode de réalisation, le procédé comprend les étapes consistant à écrire des données régulières dans les premières cellules mémoire au moyen du premier cycle d'effacement ou de programmation, et écrire de fausses données dans les secondes cellules mémoire au moyen du second cycle d'effacement ou de programmation.

Des modes de réalisation de l'invention concernent également une mémoire non volatile comprenant un plan de cellules mémoire, et un circuit de commande configuré pour exécuter un premier cycle d'effacement ou de programmation de premières cellules mémoire de la mémoire, le premier cycle d'effacement ou de programmation comprenant les étapes consistant à : i) appliquer au moins une impulsion d'effacement ou de programmation aux cellules mémoire, ii) déterminer l'état, effacé ou programmé, des cellules mémoire, et iii) répéter les étapes i) et ii) si les cellules mémoire ne sont pas dans l'état souhaité. Le circuit de commande est configuré en outre pour exécuter un second cycle d'effacement ou de programmation de secondes cellules mémoire comprenant l'application d'un nombre prédéterminé d'impulsions d'effacement ou de programmation aux secondes cellules mémoire.

Selon un mode de réalisation, le circuit de commande est configuré pour déterminer le nombre prédéterminé d'impulsions d'effacement ou de programmation en fonction d'un premier nombre d'impulsions appliquées à des premières cellules mémoire pendant au moins un premier cycle d'effacement ou de programmation de premières cellules mémoire.

Selon un mode de réalisation, le circuit de commande, lorsqu'il exécute le second cycle d'effacement ou de programmation, est configuré pour : iv) appliquer au moins une impulsion d'effacement ou de programmation aux cellules mémoire, v) déterminer l'état, effacé ou programmé, des cellules mémoire, et vi) répéter les étapes iv) et v) jusqu'à ce que le nombre prédéterminé d'impulsions d'effacement ou de programmation soit appliqué aux secondes cellules mémoire.

Selon un mode de réalisation, le circuit de commande est configuré pour stocker le nombre d'impulsions appliquées aux premières cellules mémoire pour les mettre dans l'état souhaité, lors de l'exécution du premier cycle d'effacement ou de programmation.

Selon un mode de réalisation, le circuit de commande est configuré pour déterminer le nombre prédéterminé d'impulsions d'effacement ou de programmation selon au moins l'une des méthodes suivantes : le nombre prédéterminé d'impulsions d'effacement ou de programmation est fonction du nombre d'impulsions d'effacement ou de programmation appliquées aux premières cellules mémoire pendant un premier cycle d'effacement ou de programmation de premières cellules mémoire ; le nombre prédéterminé d'impulsions d'effacement ou de programmation est fonction d'une valeur moyenne de nombres d'impulsions d'effacement ou de programmation appliquées aux premières cellules mémoire pendant une pluralité de premiers cycles d'effacement ou de programmation de premières cellules mémoire ; le nombre prédéterminé d'impulsions d'effacement ou de programmation est fonction d'une valeur maximale de nombres d'impulsions d'effacement ou de programmation appliquées aux premières cellules mémoire pendant une pluralité de premiers cycles d'effacement ou de programmation de premières cellules mémoire.

Selon un mode de réalisation, le circuit de commande est configuré pour écrire des données régulières dans les premières cellules mémoire au moyen du premier cycle d'effacement ou de programmation, et écrire de fausses données dans les secondes cellules mémoire au moyen du second cycle d'effacement ou de programmation.

Selon un mode de réalisation, le circuit de commande est configuré pour mémoriser des adresses de secondes cellules mémoire, et appliquer le second cycle d'effacement ou de programmation uniquement aux secondes cellules mémoire.

Des modes de réalisation de l'invention concernent également un dispositif électronique comprenant une mémoire non volatile selon l'invention.

Des modes de réalisation de la présente invention font à présent l'objet d'une description à titre non limitatif en relation avec les dessins joints, parmi lesquels :
- La figure 1, précédemment décrite, est un organigramme illustrant un procédé conventionnel de réalisation d'un cycle d'effacement ou de programmation d'une cellule mémoire,
- La figure 2 est un schéma fonctionnel d'un mode de réalisation d'un dispositif mémoire selon la présente invention,
- Les figures 3A et 3B sont des organigrammes illustrant des cycles d'effacement ou de programmation selon un mode de réalisation de la présente invention,
- La figure 4 est un organigramme illustrant un cycle d'effacement ou de programmation selon un autre mode de réalisation de la présente invention,
- La figure 5 est un organigramme illustrant un cycle d'effacement ou de programmation selon encore un autre mode de réalisation de la présente invention, et
- La figure 6 illustre un dispositif électronique comprenant un dispositif mémoire selon la présente invention.

La figure 2 illustre schématiquement une mémoire non volatile MEM selon un mode de réalisation de la présente invention. La mémoire MEM comprend un plan MA de cellules mémoire, un décodeur de ligne RDEC, un décodeur de colonne CDEC, un bloc de verrous de programmation PL, un groupe de transistors de sélection de colonne CST, un bloc d'amplificateurs de lecture SA, un port d'entrée/sortie IOP et un circuit de commande CCT.

Le plan mémoire comprend des cellules mémoire (non représentées) connectées à des lignes de mots WL et à des lignes de bits BL. Le décodeur de ligne RDEC est connecté aux lignes de mots, les verrous de programmation PL sont connectés à une extrémité des lignes de bits, et les amplificateurs de lecture SA sont couplés à une autre extrémité des lignes de bits par l'intermédiaire des transistors de sélection CST. Ces derniers sont commandés par le décodeur de colonne CDEC par l'intermédiaire de lignes de sélection de colonne CSL.

Le circuit de commande CCT est couplé à une entrée/sortie du port IOP, à des entrées des verrous de programmation PL et à des sorties des amplificateurs de lecture SA via un bus BS. Le circuit de commande reçoit, via le port IOP, des commandes d'effacement, de programmation ou de lecture envoyées par un dispositif de commande hôte (non représenté). Ces commandes comprennent des adresses de cellules mémoire et des données à écrire. Dans un mode de réalisation, le circuit de commande CCT est configuré pour recevoir des commandes d'écriture au lieu de commandes d'effacement et de programmation, et les exécute en réalisant des cycles d'effacement et de programmation correspondants.

Les données à écrire dans le plan mémoire sont chargées dans les verrous de programmation PL, tandis que les données lues dans le plan mémoire sont fournies par l'amplificateur de lecture SA. Les adresses ADD d'effacement, de programmation ou de lecture sont chargées dans le décodeur de ligne RDEC et le décodeur de colonne CDEC, le premier recevant les bits de poids fort ADD_{M} de celles-ci et le second recevant les bits de poids faible ADD_{L} de celles-ci.

Le circuit de commande peut inclure un microprocesseur avec une mémoire de programmation (non représentée) ou une machine d'état, différents registres, différents circuits d'alimentation pour fournir les tensions nécessaires aux opérations d'effacement, de programmation, de lecture, ainsi que les tensions nécessaires à la détermination des états des cellules mémoire par l'intermédiaire des amplificateurs de lecture.

Le plan mémoire peut comprendre deux types T1, T2 de cellules mémoire. Les cellules mémoire de type T1 sont utilisées pour stocker des données régulières (données d'application), tandis que les cellules mémoire de type T2 sont utilisées comme cellules mémoire « factices », pour stocker de fausses données.

L'emplacement des cellules mémoire factices peut être prédéfini lors de la conception ou de la personnalisation de la mémoire. Il peut également être défini de manière dynamique par le dispositif de commande hôte couplé à la mémoire, en envoyant à celle-ci une commande de configuration spécifique indiquant des emplacements de cellules mémoire factices, ou des commandes d'écriture factices désignant ces emplacements.

Les cellules mémoire factices sont situées de préférence dans une même page (un ensemble de cellules mémoire connectées à une même ligne de mots WL) ou dans le même secteur (un ensemble de pages adjacentes), ou sinon dans différentes pages ou différents secteurs contenant uniquement des cellules mémoire factices. Dans un mode de réalisation, le statut des cellules mémoire, une fois défini comme étant T2, est irréversible tout au long de la durée de vie de la mémoire.

Le circuit de commande CCT est configuré pour réaliser deux types de cycles d'effacement EC1, EC2 et deux types de cycles de programmation PC1, PC2. Les cycles EC1, PC1 sont respectivement des cycles réguliers d'effacement et de programmation appliqués à des cellules mémoire de type T1. Les cycles EC2, PC2 sont respectivement des cycles factices d'effacement et de programmation appliqués à des cellules mémoire de type T2.

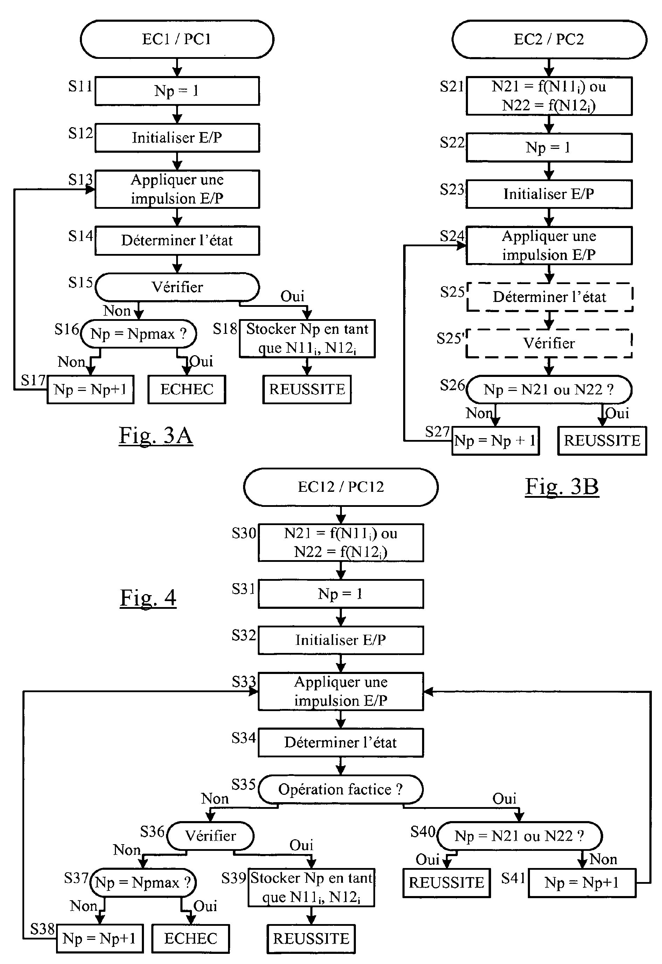

Les cycles EC1, PC1 ont la même structure et sont illustrés par le même organigramme en figure 3A. Chacun d'eux comprend les étapes S11 à S17. A l'étape S11, la variable Np mentionnée précédemment est mise à une valeur initiale, ici 1. A l'étape S12, l'opération d'effacement ou de programmation est initialisée. Cette initialisation comprend par exemple la fourniture des tensions appropriées pour le cycle d'effacement ou de programmation (y compris l'activation d'une pompe de charge, par exemple), l'application des adresses ADD_{M}, ADD_{L} aux décodeurs de ligne et de colonne, et, pour le cycle de programmation PC1, le stockage des données dans les verrous de programmation PL. A l'étape S 13, le circuit de commande applique une impulsion d'effacement ou de programmation à des cellules mémoire désignées. A l'étape S14, le circuit de commande détermine les états des cellules mémoire. Cette opération est réalisée par exemple en détectant les tensions de seuil des cellules mémoire sous une tension de lecture spécifique, au moyen des amplificateurs de lecture SA. Chaque amplificateur de lecture fournit en sortie un bit qui donne une indication de l'état d'une cellule mémoire à laquelle il est couplé.

A l'étape S 15, le circuit de commande vérifie si les états des cellules mémoire correspondent à l'état souhaité, effacé ou programmé. Sinon, à l'étape S16, le circuit de commande vérifie si Np est égal à un nombre maximum d'impulsions Npmax pouvant être appliquées. Si la réponse est oui, le cycle est interrompu avec le statut « échec ». Si Np est inférieur à Npmax, le circuit de commande augmente Np de un à l'étape S17, et revient à l'étape S13 pour appliquer une autre impulsion d'effacement ou de programmation aux cellules mémoire.

Si, à l'étape S15, les états des cellules mémoire correspondent aux états souhaités, le cycle d'effacement ou de programmation est interrompu avec le statut « réussite ». Avant d'interrompre le cycle, à l'étape S18, le circuit de commande stocke la variable Np dans un registre, respectivement en tant que valeur de référence d'effacement N11ᵢ ou valeur de référence de programmation N12ᵢ, « i » représentant le rang du cycle en cours EC1 ou PC1 parmi une pluralité de cycles de même nature, d'effacement ou de programmation, où des variables similaires ont été stockées.

Les cycles d'effacement ou de programmation EC2, PC2 ont la même structure et sont illustrés par le même organigramme en figure 3B. Chacun d'eux comprend les étapes S21 à S27.

A l'étape S21, en cas de réalisation du cycle d'effacement EC2, un paramètre d'effacement factice N21 est fixé en fonction des valeurs de référence N11ᵢ des cycles d'effacement réguliers EC1 précédents. En cas de réalisation du cycle de programmation PC2, un paramètre de programmation factice N22 est fixé en fonction des valeurs de référence N12ᵢ des cycles de programmation réguliers PC1 précédents.

A l'étape S22, la variable Np est mise à 1. A l'étape S23, l'opération d'effacement ou de programmation est initialisée. A l'étape S24, le circuit de commande applique une impulsion d'effacement ou de programmation à des cellules mémoire désignées. A l'étape 25, qui est facultative, le circuit de commande détermine les états des cellules mémoire. A l'étape S26, le circuit de commande vérifie si Np est égal à N21 si le cycle d'effacement EC2 est en cours d'exécution ou égal à N22 si le cycle de programmation PC2 est en cours d'exécution. Si la réponse est oui, le circuit de commande interrompt le cycle avec le statut « réussite ». Si la réponse est non, Np est augmenté de un à l'étape S27 et le circuit de commande revient à l'étape S24 pour appliquer une autre impulsion aux cellules mémoire concernées.

Il apparaîtra clairement à l'homme de l'art que l'étape d'initialisation S22 est de préférence identique à l'étape S12 réalisée au cycle EC1 ou PC1, et que l'étape S25, bien que facultative puisque non nécessaire au cycle d'effacement ou de programmation factice, est prévue afin que le cycle EC2 ressemble au cycle EC1 et que le cycle PC2 ressemble au cycle PC1 le plus possible en termes de consommation électrique, de tensions générées, de nombre d'étapes réalisées, etc.

Dans un mode de réalisation, une étape de vérification S25' peut être incluse dans les cycles EC2, PC2, comme illustré en figure 3B, de sorte que le cycle ressemble encore plus aux cycles EC1, PC1, mais le résultat de la vérification n'est pas pris en compte, de sorte que l'étape S26 est réalisée quel que soit le résultat.

Dans un mode de réalisation, l'étape S21 est réalisée par le circuit de commande avant l'exécution des cycles EC2, PC2, en tant que calcul de fond, par exemple chaque fois qu'une nouvelle valeur de référence N11ᵢ ou N12ᵢ a été stockée après un cycle EC1 ou PC1, en prévision de futurs cycles factices EC2, PC2.

Les cycles EC1, EC2, PC1, PC2 sont susceptibles de divers autres modes de réalisation. Par exemple, Np peut être mis à une valeur initiale « n » à l'étape S11 ou S22 et augmenté de « n » à l'étape S 16 ou S27. Dans ce cas, les étapes S13 ou S24 incluent l'application de « n » impulsions d'effacement ou de programmation aux cellules mémoire. En outre, l'étape S26 peut consister à vérifier si Np est supérieur ou égal à N21 ou N22 au lieu de vérifier les strictes égalités, en particulier si le nombre « n » d'impulsions d'effacement ou de programmation appliquées aux cellules mémoire à l'étape S24 est augmenté progressivement au fil du vieillissement des cellules.

La figure 4 est un organigramme illustrant un mode de réalisation d'un cycle d'effacement EC12 ou d'un cycle de programmation PC12 selon la présente invention, tous deux ayant la même structure et étant illustrés par le même organigramme. Le cycle EC12 est le résultat de la fusion du cycle EC1 avec le cycle EC2 et peut être un cycle d'effacement régulier ou un cycle d'effacement factice. De même, le cycle P12 est le résultat de la fusion du cycle PC1 avec le cycle PC2 et peut être un cycle de programmation régulier ou un cycle de programmation factice.

Les cycles EC12, PC12 comprennent les étapes S30 à S41. L'étape S30 est équivalente à l'étape S21 et consiste à déterminer le paramètre N21 ou N22 en fonction de valeurs de référence N11ᵢ ou N12ᵢ de cycles réguliers précédents EC12, PC12. Comme indiqué ci-dessus, ce calcul peut être réalisé à un autre moment avant le lancement du cycle, par exemple à la fin d'un cycle précédent EC12, PC12 relatif à une opération d'effacement ou de programmation régulière, après l'étape S39 décrite ci-après.

L'étape S31 est équivalente à l'étape S11 ou S22 et consiste à mettre Np à 1. L'étape S32 est équivalente à l'étape S12 ou S23 et consiste à initialiser l'opération d'effacement ou de programmation. L'étape S33 est équivalente à l'étape S13 ou S24 et consiste à appliquer une impulsion d'effacement ou de programmation aux cellules mémoire concernées. L'étape S34 est équivalente à l'étape S14 ou S25 et consiste à déterminer les états des cellules mémoire.

A l'étape S35, le circuit de commande détermine si le cycle en cours d'effacement ou de programmation EC12, PC12 est un cycle régulier d'effacement ou de programmation ou un cycle factice d'effacement ou de programmation. Cette détermination consiste par exemple à déterminer si le cycle en cours est réalisé sur des cellules mémoire du second type T2 ou du premier type T1, en examinant l'adresse reçue dans la commande d'effacement ou de programmation et en la comparant avec une plage d'adresses correspondant à des pages ou secteurs factices. Dans un autre mode de réalisation, les informations selon lesquelles le cycle en cours est un cycle « régulier » ou « factice » sont incluses dans la commande elle-même. Pour gagner du temps lors de l'exécution de l'étape S35, cette détermination peut être réalisée au tout début du cycle EC12, PC12, avant l'exécution de l'étape S30, et un drapeau peut être mis à une valeur logique indiquant si le cycle en cours est régulier ou factice. Dans ce cas, l'étape S35 consiste uniquement à tester la valeur de ce drapeau.

Si le cycle en cours est un cycle régulier, le circuit de commande emprunte une première branche d'exécution comprenant les étapes S36, S37, S38, S39 qui sont équivalentes aux étapes S 15, S16, S 17, S18. Si le cycle en cours est un cycle factice, le circuit de commande emprunte une seconde branche d'exécution comprenant les étapes S40, S41 qui sont équivalentes aux étapes S26, S27.

Première branche : à l'étape S36, le circuit de commande vérifie si les états des cellules mémoire correspondent aux états souhaités. Si les états ne correspondent pas, à l'étape S37, le circuit de commande vérifie si Np appliqué est égal à Npmax. Si la réponse est oui, le cycle est interrompu avec le statut « échec ». Si la réponse est non, Np est augmenté de un à l'étape S38, et le circuit de commande revient à l'étape S33. Si la réponse à l'étape S36 est oui, Np est chargée dans un registre comme la valeur de référence d'impulsion N11i ou N12i à l'étape S39, et le circuit de commande interrompt le cycle avec le statut « réussite ».

Seconde branche : à l'étape S40, le circuit de commande vérifie si Np est égal à N21 (en cas de cycle d'effacement factice) ou N22 (en cas de cycle de programmation factice). Si la réponse est oui, le circuit de commande interrompt le cycle avec le statut « réussite ». Si la réponse est non, Np est augmenté de un à l'étape 41, et le circuit de commande revient à l'étape S33.

Dans une variante de réalisation de la seconde branche, une étape de vérification est réalisée avant l'étape S40, de sorte que les première et seconde branches se ressemblent plus étroitement, en termes de consommation électrique, de tensions générées, de nombre d'étapes réalisées, etc. Toutefois, dans ce cas, le résultat de l'étape de vérification n'est pas pris en compte.

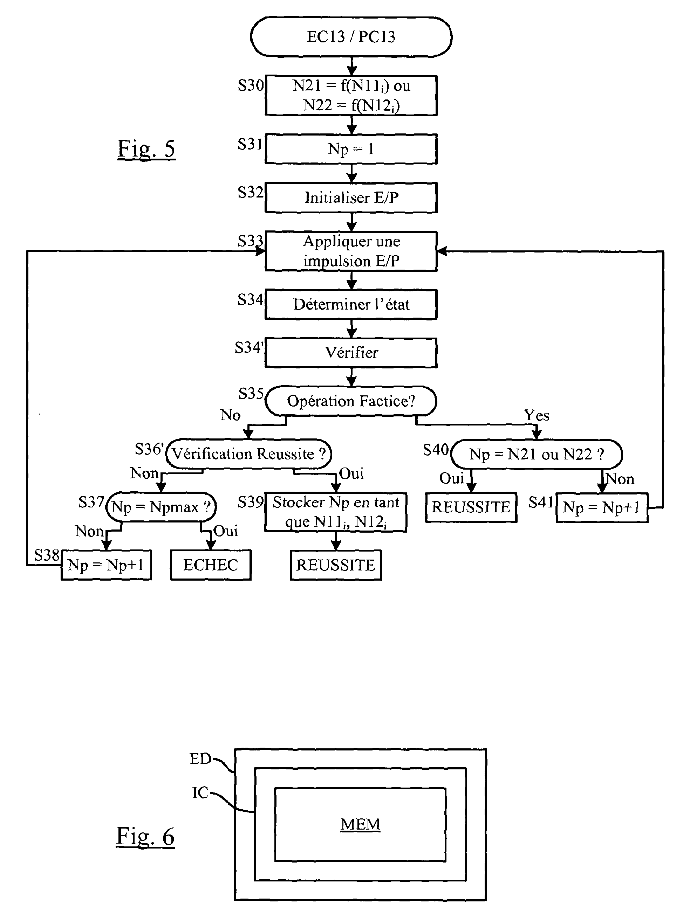

La figure 5 est un organigramme illustrant un autre mode de réalisation d'un cycle d'effacement EC13 ou d'un cycle de programmation PC13 selon la présente invention. Les cycles EC13, PC 13 diffèrent du cycle EC 12, PC 12 en ce que l'étape de vérification, désignée ici sous le nom d'étape S34', a été placée après l'étape S34 et avant l'étape S35. Le résultat de la vérification est ensuite stocké, par exemple en tant que « drapeau de réussite ». Dans la première branche, l'étape de vérification précédente S36 est remplacée par une étape « Vérification réussite ? » S36', dans laquelle le circuit de commande vérifie simplement si la vérification à l'étape S34' a été concluante, en contrôlant par exemple le « drapeau de réussite ». Ainsi, les cycles d'effacement et de programmation EC13, PC13 dans le cas d'une opération factice ou d'une opération de données se ressemblent plus étroitement, en termes de consommation électrique, de tensions générées, de nombre d'étapes réalisées, etc.

Différents algorithmes peuvent être prévus pour la détermination du paramètre d'effacement factice N21 en fonction de différentes valeurs de référence N11ᵢ renvoyées par des cycles d'effacement réguliers, et pour la détermination de la valeur de référence de programmation factice N22 en fonction de différentes valeurs de référence N12ᵢ renvoyées par des cycles de programmation réguliers. Ces algorithmes sont conçus de préférence de sorte qu'un cycle factice d'effacement ou de programmation ressemble à un cycle régulier d'effacement ou de programmation en ce qui concerne le nombre d'impulsions appliquées aux cellules mémoire et la détermination et la vérification des états des cellules mémoire. Ces algorithmes peuvent différer beaucoup selon l'application où l'invention est mise en oeuvre, selon le mode d'utilisation des différentes pages ou différents secteurs du plan mémoire, et selon le mode et le moment d'utilisation des cellules mémoire factices.

Des exemples non restrictifs sont indiqués ci-après :
1) N21 est égal à ou fonction de la dernière valeur de référence N11ᵢ stockée pendant le dernier cycle régulier d'effacement, et N22 est égal à ou fonction de la dernière valeur de référence N12ᵢ stockée pendant le dernier cycle régulier de programmation, ou
2) N21 est une valeur moyenne de « I » dernières valeurs de référence N11ᵢ stockées pendant « I » derniers cycles d'effacement réguliers, ou fonction de celles-ci, et N22 est la valeur moyenne de « I » dernières valeurs de référence N12ᵢ stockées pendant « I » derniers cycles de programmation réguliers, ou fonction de celles-ci, ou
3) N21 est la valeur maximale de «I » dernières valeurs de référence N11ᵢ stockées pendant « I » derniers cycles d'effacement réguliers, ou fonction de celles-ci, et N22 est la valeur maximale de « I » dernières valeurs de référence N12ᵢ stockées pendant « I » derniers cycles de programmation réguliers, ou fonction de celles-ci.

Ces algorithmes peuvent être modifiés en ajoutant ou en soustrayant aux valeurs susmentionnées des valeurs aléatoires fournies par un générateur de nombres aléatoires, ou des valeurs de polarisation spécifiques. Dans d'autres modes de réalisation, l'âge des cellules mémoire peut également être pris en compte, par exemple en ne considérant que les valeurs de référence N11ᵢ, N12ᵢ renvoyées par des cycles réguliers d'effacement ou de programmation sur des cellules mémoire au sein d'une plage d'âges spécifique. L'emplacement des cellules mémoire à l'intérieur du plan mémoire par rapport à celui des cellules mémoire factices peut également être pris en compte. Par exemple, l'algorithme peut ne considérer que les valeurs de référence N11ᵢ, N12ᵢ renvoyées par les cycles réguliers d'effacement ou de programmation réalisés sur des cellules mémoire à l'intérieur d'une zone spécifique, par exemple une zone où des données sensibles sont écrites pendant un calcul cryptographique.

Dans certains modes de réalisation, la mémoire peut également comprendre des secteurs de données avec différentes endurances. Le tableau suivant illustre des exemples de méthodes permettant de déterminer N21 en fonction de N11(A) et N11(B) lorsque la mémoire comprend un premier secteur de données « A » avec une première durée d'endurance, par exemple 10 000 cycles, et un second secteur de données « B » avec une seconde durée d'endurance, par exemple 1 000 000 de cycles. La référence « bv » désigne une valeur de polarisation, par exemple -1, 0 ou 1. N11 (A) et N11(B) sont elles-mêmes fonction de valeurs de référence d'effacement N11ᵢ stockées pour les secteurs A et B considérés, et peuvent être par exemple la dernière valeur de référence N11ᵢ, la valeur moyenne de «I » dernières valeurs de référence N11ᵢ, ou la valeur maximale de « I » dernières valeurs de référence N11ᵢ, selon les méthodes décrites ci-dessus. Enfin, ces exemples sont en effet applicables à la détermination de N22 en fonction de N12.

| | Initiale (cellules nouvelles) | Demi-vie (cellules âgées) |
|---|---|---|
| | N11(A) = 1 | N11(A) = 2 |
| | N11(B) = 1 | N11(B) = 6 |
| 1) N21 =N11(A) | N21 = 1 | N21 = 2 |
| 2) N21 = max(N11(A), N11(B)) | N21 = 1 | N21 = 6 |
| 3) N21 = moyenne(N11(A), N11(B)) | N21 = 1 | N2 = 4 |
| 4) N21 = N11(B) + bv | N21 = 1+bv | N2 = 6+bv |

Bien que l'invention ait été prévue initialement à des fins de sécurité pour exécuter des cycles factices d'effacement ou de programmation qui ressemblent aux cycles réguliers d'effacement ou de programmation, dans certains modes de réalisation, les cycles d'effacement et de programmation EC2, PC2 selon la présente invention peuvent être utilisés à des fins autres que l'exécution d'opérations factices. Par exemple, lorsqu'un grand nombre de cycles d'effacement ou de programmation doit être réalisé sur un vaste secteur du plan mémoire comprenant des cellules mémoire du même âge, les cycles réguliers d'effacement/de vérification ou de programmation/ vérification EC1, PC1 peuvent être réalisés sur des premières cellules mémoire de la zone considérée, puis, si les paramètres de référence N11, N12 sont stables, les cycles d'effacement ou de programmation EC2, PC2 sont réalisés sur d'autres cellules mémoire sans vérification de l'état des cellules mémoire, afin de réduire le temps global d'effacement ou de programmation du vaste secteur. Dans ce cas, l'étape de détermination S25 des cycles EC2, PC2 n'est pas réalisée afin de gagner du temps.

Il apparaîtra également clairement à l'homme de l'art que l'invention est susceptible de diverses autres mises en oeuvre et applications. En particulier, l'invention peut être appliquée à des mémoires FLASH ayant des architectures de type NON OU ou NON ET, des mémoires EEPROM, ainsi que n'importe quel autre type de mémoire effaçable et programmable au moyen du processus d'effacement/de vérification et de programmation/vérification. Ainsi, l'invention ne se limite pas à des cellules mémoire comprenant des transistors à grille flottante, mais concerne tout type de cellule mémoire à laquelle des impulsions multiples peuvent être appliquées afin d'assurer un effacement et/ou une programmation.

Il va également de soi qu'il n'est pas nécessaire que les cellules mémoire désignées par une adresse soient toutes correctement effacées et/ou programmées pour que le procédé soit considéré comme ayant réussi, mais qu'un certain seuil peut être fixé, au-delà ou en-deçà duquel l'opération est considérée comme ayant réussi ou échoué.

La figure 6 illustre un dispositif électronique ED comprenant un circuit intégré IC à l'intérieur duquel est incorporée une mémoire non volatile MEM selon la présente invention. Le dispositif électronique ED peut être une carte à puce sans contact, une étiquette, un téléphone mobile, un assistant personnel numérique, etc.

## Revendications

1. Procédé de programmation ou d'effacement de cellules mémoire d'une mémoire non volatile comprenant :
- un premier cycle d'effacement ou de programmation de premières cellules mémoire (T1), comprenant les étapes consistant à :
i) appliquer (S11, S33) au moins une impulsion d'effacement ou de programmation (Np) aux cellules mémoire,
ii) déterminer (S 14, S34) l'état, effacé ou programmé, des cellules mémoire, et
iii) répéter les étapes i) et ii) si les cellules mémoire ne sont pas dans l'état souhaité,
**caractérisé en ce qu'**il comprend en outre un second cycle d'effacement ou de programmation de secondes cellules mémoire (T2), comprenant l'application (S24, S33) d'un nombre prédéterminé (N21, N22) d'impulsions d'effacement ou de programmation aux secondes cellules mémoire.

2. Procédé selon la revendication 1, dans lequel le nombre prédéterminé (N21, N22) d'impulsions d'effacement ou de programmation est fonction d'un premier nombre d'impulsions (N11ᵢ, N12ᵢ) appliquées à des premières cellules mémoire (T1) pendant au moins un premier cycle d'effacement ou de programmation de premières cellules mémoire.

3. Procédé selon l'une des revendications 1 ou 2, dans lequel le second cycle comprend les étapes consistant à :
iv) appliquer (S24, S33) au moins une impulsion d'effacement ou de programmation (Np) aux cellules mémoire,
v) déterminer (S25, S34) l'état, effacé ou programmé, des cellules mémoire, et
vi) répéter les étapes iv) et v) jusqu'à ce que le nombre prédéterminé (N21, N22) d'impulsions d'effacement ou de programmation soit appliqué aux secondes cellules mémoire.

4. Procédé selon l'une des revendications 1 à 3, comprenant une étape consistant à vérifier (S35) si le cycle d'effacement ou de programmation est réalisé sur la première (T1) ou la seconde (T2) cellule mémoire.

5. Procédé selon l'une des revendications 1 à 4, dans lequel le premier cycle d'effacement ou de programmation comprend une étape (S18, S39) de stockage du nombre d'impulsions (N11, N12) appliquées aux premières cellules mémoire pour les mettre dans l'état souhaité.

6. Procédé selon l'une des revendications 1 à 5, dans lequel le nombre prédéterminé (N21, N22) d'impulsions d'effacement ou de programmation est déterminé selon au moins l'une des méthodes suivantes :
- le nombre prédéterminé (N21, N22) d'impulsions d'effacement ou de programmation est fonction du nombre (N11ᵢ, N12ᵢ) d'impulsions d'effacement ou de programmation appliquées aux premières cellules mémoire pendant un premier cycle d'effacement ou de programmation de premières cellules mémoire ;
- le nombre prédéterminé (N21, N22) d'impulsions d'effacement ou de programmation est fonction d'une valeur moyenne de nombres (N11ᵢ, N12ᵢ) d'impulsions d'effacement ou de programmation appliquées aux premières cellules mémoire pendant une pluralité de premiers cycles d'effacement ou de programmation de premières cellules mémoire ;
- le nombre prédéterminé (N21, N22) d'impulsions d'effacement ou de programmation est fonction d'une valeur maximale de nombres (N11ᵢ, N12ᵢ) d'impulsions d'effacement ou de programmation appliquées aux premières cellules mémoire pendant une pluralité de premiers cycles d'effacement ou de programmation de premières cellules mémoire.

7. Procédé selon les revendications 1 à 6, comprenant les étapes consistant à :
- écrire des données régulières dans les premières cellules mémoire (T1) au moyen du premier cycle d'effacement ou de programmation, et
- écrire de fausses données dans les secondes cellules mémoire (T2) au moyen du second cycle d'effacement ou de programmation.

8. Mémoire non volatile (MEM) comprenant :
- un plan (MA) de cellules mémoire (MA), et
- un circuit de commande (CCT) configuré pour exécuter un premier cycle d'effacement ou de programmation de premières cellules mémoire (T1) de la mémoire (MA), le premier cycle d'effacement ou de programmation comprenant les étapes consistant à :
i) appliquer (S11, S33) au moins une impulsion d'effacement ou de programmation (Np) aux cellules mémoire,
ii) déterminer (S14, S34) l'état, effacé ou programmé, des cellules mémoire, et
iii) répéter les étapes i) et ii) si les cellules mémoire ne sont pas dans l'état souhaité,
**caractérisée en ce que** le circuit de commande est configuré en outre pour exécuter un second cycle d'effacement ou de programmation de secondes cellules mémoire (T2) comprenant l'application (S24, S33) d'un nombre prédéterminé (N21, N22) d'impulsions d'effacement ou de programmation aux secondes cellules mémoire.

9. Mémoire non volatile selon la revendication 8, dans laquelle le circuit de commande est configuré pour déterminer le nombre prédéterminé (N21, N22) d'impulsions d'effacement ou de programmation en fonction d'un premier nombre d'impulsions (N11ᵢ, N12ᵢ) appliquées à des premières cellules mémoire (T1) pendant au moins un premier cycle d'effacement ou de programmation de premières cellules mémoire.

10. Mémoire non volatile selon l'une des revendications 8 ou 9, dans laquelle le circuit de commande, lorsqu'il exécute le second cycle d'effacement ou de programmation, est configuré pour :
iv) appliquer (S24, S33) au moins une impulsion d'effacement ou de programmation (Np) aux cellules mémoire,
v) déterminer (S25, S34) l'état, effacé ou programmé, des cellules mémoire, et
vi) répéter les étapes iv) et v) jusqu'à ce que le nombre prédéterminé (N21, N22) d'impulsions d'effacement ou de programmation soit appliqué aux secondes cellules mémoire.

11. Mémoire non volatile selon l'une des revendications 8 à 10, dans laquelle le circuit de commande est configuré pour stocker le nombre d'impulsions (N11, N12) appliquées aux premières cellules mémoire pour les mettre dans l'état souhaité, lors de l'exécution du premier cycle d'effacement ou de programmation.

12. Mémoire non volatile selon l'une des revendications 8 à 11, dans laquelle le circuit de commande est configuré pour déterminer le nombre prédéterminé (N21, N22) d'impulsions d'effacement ou de programmation selon au moins l'une des méthodes suivantes :
- le nombre prédéterminé (N21, N22) d'impulsions d'effacement ou de programmation est fonction du nombre (N11ᵢ, N12ᵢ) d'impulsions d'effacement ou de programmation appliquées aux premières cellules mémoire pendant un premier cycle d'effacement ou de programmation de premières cellules mémoire ;
- le nombre prédéterminé (N21, N22) d'impulsions d'effacement ou de programmation est fonction d'une valeur moyenne de nombres (N11ᵢ, N12ᵢ) d'impulsions d'effacement ou de programmation appliquées aux premières cellules mémoire pendant une pluralité de premiers cycles d'effacement ou de programmation de premières cellules mémoire ;
- le nombre prédéterminé (N21, N22) d'impulsions d'effacement ou de programmation est fonction d'une valeur maximale de nombres (N11ᵢ, N12ᵢ) d'impulsions d'effacement ou de programmation appliquées aux premières cellules mémoire pendant une pluralité de premiers cycles d'effacement ou de programmation de premières cellules mémoire.

13. Mémoire non volatile selon l'une des revendications 8 à 12, dans laquelle le circuit de commande est configuré pour :
- écrire des données régulières dans les premières cellules mémoire (T1) au moyen du premier cycle d'effacement ou de programmation, et
- écrire de fausses données dans les secondes cellules mémoire (T2) au moyen du second cycle d'effacement ou de programmation.

14. Mémoire non volatile selon l'une des revendications 8 à 13, dans laquelle le circuit de commande est configuré pour :
- mémoriser des adresses de secondes cellules mémoire (T2), et
- appliquer le second cycle d'effacement ou de programmation uniquement aux secondes cellules mémoire.

15. Dispositif électronique (ED) comprenant une mémoire non volatile (MEM) selon l'une des revendications 8 à 14.

## Patentansprüche

1. Verfahren zum Programmieren oder Löschen von Speicherzellen eines nicht-flüchtigen Speichers, umfassend:
- einen ersten Zyklus des Löschens oder des Programmierens von ersten Speicherzellen (T1), der die folgenden Schritte umfasst, die darin bestehen:
i) wenigstens einen Lösch- oder Programmierimpuls (Np) auf die Speicherzellen anzuwenden (S11, S33),
ii) den Zustand, entweder gelöscht oder programmiert, der Speicherzellen zu bestimmen (S 14, S34), und
iii) die Schritte i) und ii) zu wiederholen, wenn die Speicherzellen nicht im gewünschten Zustand sind,
**dadurch gekennzeichnet, dass** es ferner einen zweiten Zyklus des Löschens oder des Programmierens von zweiten Speicherzellen (T2) umfasst, der die Anwendung (S24, S33) einer vorbestimmten Anzahl (N21, N22) von Lösch- oder Programmierimpulsen auf die zweiten Speicherzellen umfasst.

2. Verfahren nach Anspruch 1, bei dem die vorbestimmte Anzahl (N21, N22) von Lösch- oder Programmierimpulsen von einer ersten Anzahl von Impulsen (N11i, N 12i) abhängt, die auf erste Speicherzellen (T1) während wenigstens eines ersten Zyklus des Löschens oder des Programmierens von ersten Speicherzellen angewendet werden.

3. Verfahren nach einem der Ansprüche 1 oder 2, bei dem der zweite Zyklus die folgenden Schritte umfasst, die darin bestehen:
iv) wenigstens einen Lösch- oder Programmierimpuls (Np) auf die Speicherzellen anzuwenden (S24, S33),
v) den Zustand, entweder gelöscht oder programmiert, der Speicherzellen zu bestimmen (S25, S34), und
vi) die Schritte iv) und v) zu wiederholen, bis die vorbestimmte Anzahl (N21, N22) von Lösch- oder Programmierimpulsen auf die zweiten Speicherzellen angewendet wird.

4. Verfahren nach einem der Ansprüche 1 bis 3, umfassend einen Schritt, der darin besteht zu prüfen (S35), ob der Lösch- oder Programmierzyklus auf die erste (T1) oder auf die zweite (T2) Speicherzelle angewendet wird.

5. Verfahren nach einem der Ansprüche 1 bis 4, bei dem der erste Lösch- oder Programmierzyklus einen Schritt (S18, S39) der Speicherung der Anzahl von Impulsen (N11, N12) umfasst, die auf die ersten Speicherzellen angewendet werden, um sie in den gewünschten Zustand zu setzen.

6. Verfahren nach einem der Ansprüche 1 bis 5, bei dem die vorbestimmte Anzahl (N21, N22) von Lösch- oder Programmierimpulsen nach wenigstens einer der folgenden Methoden bestimmt wird:
- die vorbestimmte Anzahl (N21, N22) von Lösch- oder Programmierimpulsen hängt von der Anzahl (N11i, N12i) von Lösch- oder Programmierimpulsen ab, die auf die ersten Speicherzellen während eines ersten Zyklus des Löschens oder des Programmierens von ersten Speicherzellen angewendet werden;
- die vorbestimmte Anzahl (N21, N22) von Lösch- oder Programmierimpulsen hängt von einem Mittelwert von Anzahlen (N11i, N12i) von Lösch- oder Programmierimpulsen ab, die auf die ersten Speicherzellen während einer Vielzahl von ersten Zyklen des Löschens oder des Programmierens von ersten Speicherzellen angewendet werden;
- die vorbestimmte Anzahl (N21, N22) von Lösch- oder Programmierimpulsen hängt von einem Maximalwert von Anzahlen (N11i, N12i) von Lösch- oder Programmierimpulsen ab, die auf die ersten Speicherzellen während einer Vielzahl von ersten Zyklen des Löschens oder des Programmierens von ersten Speicherzellen angewendet werden.

7. Verfahren nach den Ansprüchen 1 bis 6, umfassend die folgenden Schritte, die darin bestehen:
- verlässliche Daten in die ersten Speicherzellen (T1) anhand des ersten Lösch- oder Programmierzyklus zu schreiben, und
- falsche Daten in die zweiten Speicherzellen (T2) anhand des zweiten Lösch- oder Programmierzyklus zu schreiben.

8. Nicht-flüchtiger Speicher (MEM) umfassend:
- eine Ebene (MA) von Speicherzellen (MA), und
- eine Steuerschaltung (CCT), die konfiguriert ist, um einen ersten Zyklus des Löschens oder des Programmierens von ersten Speicherzellen (T1) des Speichers (MA) durchzuführen, wobei der erste Lösch- oder Programmierzyklus die folgenden Schritte umfasst, die darin bestehen:
i) wenigstens einen Lösch- oder Programmierimpuls (Np) auf die Speicherzellen anzuwenden (S11, S33),
ii) den Zustand, entweder gelöscht oder programmiert, der Speicherzellen zu bestimmen (S 14, S34), und
iii) die Schritte i) und ii) zu wiederholen, wenn die Speicherzellen nicht im gewünschten Zustand sind,
**dadurch gekennzeichnet, dass** die Steuerschaltung ferner konfiguriert ist, um einen zweiten Zyklus des Löschens oder des Programmierens von zweiten Speicherzellen (T2) durchzuführen, der die Anwendung (S24, S33) einer vorbestimmten Anzahl (N21, N22) von Lösch- oder Programmierimpulsen auf die zweiten Speicherzellen umfasst.

9. Nicht-flüchtiger Speicher nach Anspruch 8, bei dem die Steuerschaltung konfiguriert ist, um die vorbestimmte Anzahl (N21, N22) von Lösch- oder Programmierimpulsen abhängig von einer ersten Anzahl von Impulsen (N11i, N12i) zu bestimmen, die auf erste Speicherzellen (T1) während wenigstens eines ersten Zyklus des Löschens oder des Programmierens von ersten Speicherzellen angewendet werden.

10. Nicht-flüchtiger Speicher nach einem der Ansprüche 8 oder 9, bei dem die Steuerschaltung beim Durchführen des zweiten Lösch- oder Programmierzyklus konfiguriert ist, um:
iv) wenigstens einen Lösch- oder Programmierimpuls (Np) auf die Speicherzellen anzuwenden (S24, S33),
v) den Zustand, entweder gelöscht oder programmiert, der Speicherzellen zu bestimmen (S25, S34), und
vi) die Schritte iv) und v) zu wiederholen, bis die vorbestimmte Anzahl (N21, N22) von Lösch- oder Programmierimpulsen auf die zweiten Speicherzellen angewendet wird.

11. Nicht-flüchtiger Speicher nach einem der Ansprüche 8 bis 10, bei dem die Steuerschaltung beim Durchführen des ersten Lösch- oder Programmierzyklus konfiguriert ist, um die Anzahl von Impulsen (N11, N12) zu speichern, die auf die ersten Speicherzellen angewendet werden, damit sie in den gewünschten Zustand gesetzt werden.

12. Nicht-flüchtiger Speicher nach einem der Ansprüche 8 bis 11, bei dem die Steuerschaltung konfiguriert ist, um die vorbestimmte Anzahl (N21, N22) von Lösch- oder Programmierimpulsen nach wenigstens einer der folgenden Methoden zu bestimmen:
- die vorbestimmte Anzahl (N21, N22) von Lösch- oder Programmierimpulsen hängt von der Anzahl (N11i, N12i) von Lösch- oder Programmierimpulsen ab, die auf die ersten Speicherzellen während eines ersten Zyklus des Löschens oder des Programmierens von ersten Speicherzellen angewendet werden;
- die vorbestimmte Anzahl (N21, N22) von Lösch- oder Programmierimpulsen hängt von einem Mittelwert von Anzahlen (N11i, N12i) von Lösch- oder Programmierimpulsen ab, die auf die ersten Speicherzellen während einer Vielzahl von ersten Zyklen des Löschens oder des Programmierens von ersten Speicherzellen angewendet werden;
- die vorbestimmte Anzahl (N21, N22) von Lösch- oder Programmierimpulsen hängt von einem Maximalwert von Anzahlen (N11i, N12i) von Lösch- oder Programmierimpulsen ab, die auf die ersten Speicherzellen während einer Vielzahl von ersten Zyklen des Löschens oder des Programmierens von ersten Speicherzellen angewendet werden.

13. Nicht-flüchtiger Speicher nach einem der Ansprüche 8 bis 12, bei dem die Steuerschaltung konfiguriert ist, um:
- verlässliche Daten in die ersten Speicherzellen (T1) anhand des ersten Lösch- oder Programmierzyklus zu schreiben, und
- falsche Daten in die zweiten Speicherzellen (T2) anhand des zweiten Lösch- oder Programmierzyklus zu schreiben.

14. Nicht-flüchtiger Speicher nach einem der Ansprüche 8 bis 13, bei dem die Steuerschaltung konfiguriert ist, um:
- Adressen von zweiten Speicherzellen (T2) zu speichern, und
- den zweiten Lösch- oder Programmierzyklus nur auf die zweiten Speicherzellen anzuwenden.

15. Elektronische Vorrichtung (ED) umfassend einen nicht-flüchtigen Speicher (MEM) nach einem der Ansprüche 8 bis 14.

## Claims

1. Method of programming or erasing memory cells of a nonvolatile memory comprising:
- a first erase or program cycle of first memory cells (T1), comprising the steps of:
i) applying (S11, S33) at least one erase or program pulse (Np) to the memory cells,
ii) determining (S14, S34) the state, erased or programmed, of the memory cells, and
iii) repeating steps i) and ii) if the memory cells are not in the desired state,
**characterized in that** it further comprises a second erase or program cycle of second memory cells (T2), comprising applying (S24, S33) a predetermined number (N21, N22) of erase or program pulses to the second memory cells.

2. Method according to claim 1, wherein the predetermined number (N21, N22) of erase or program pulses is a function of a first number of pulses (N11ᵢ, N12ᵢ) applied to first memory cells (T1) during at least one first erase or program cycle of first memory cells.

3. Method according to one of claims 1 or 2, wherein the second cycle comprises:
iv) applying (S24, S33) at least one erase or program pulse (Np) to the memory cells,
v) determining (S25, S34) the state, erased or programmed, of the memory cells, and
vi) repeating steps iv) and v) until the predetermined number (N21, N22) of erase or program pulses is applied to the second memory cells.

4. Method according to one of claims 1 to 3, comprising a step of verifying (S35) whether the erase or program cycle is performed on the first (T1) or the second (T2) memory cells.

5. Method according to one of claims 1 to 4, wherein the first erase or program cycle comprises a step (S18, S39) of storing the number of pulses (N11, N12) applied to the first memory cells to set them in the desired state.

6. Method according to one of claims 1 to 5, wherein the predetermined number (N21, N22) of erase or program pulses is determined according to at least one of the following methods:
- the predetermined number (N21, N22) of erase or program pulses is a function of the number (N11ᵢ, N12ᵢ) of erase or program pulses applied to the first memory cells during one first erase or program cycle of first memory cells;
- the predetermined number (N21, N22) of erase or program pulses is a function of an average value of numbers (N11ᵢ, N12ᵢ) of erase or program pulses applied to the first memory cells during a plurality of first erase or program cycles of first memory cells;
- the predetermined number (N21, N22) of erase or program pulses is a function of a maximum value of numbers (N11ᵢ, N12ᵢ) of erase or program pulses applied to the first memory cells during a plurality of first erase or program cycles of first memory cells.

7. Method according to claims 1 to 6, comprising:
- writing regular data in the first memory cells (T1) by means of the first erase or program cycle, and
- writing fake data in the second memory cells (T2) by means of the second erase or program cycle.

8. Nonvolatile memory (MEM) comprising:
- an array (MA) of memory cells (MA), and
- a control circuit (CCT) configured to perform a first erase or program cycle of first memory cells (T1) of the memory (MA), the first erase or program cycle comprising the steps of:
i) applying (S11, S33) at least one erase or program pulse (Np) to the memory cells,
ii) determining (S14, S34) the state, erased or programmed, of the memory cells, and
iii) repeating steps i) and ii) if the memory cells are not in the desired state,
**characterized in that** the control circuit is further configured to perform a second erase or program cycle of second memory cells (T2) comprising applying (S24, S33) a predetermined number (N21, N22) of erase or program pulses to the second memory cells.

9. Nonvolatile memory according to claim 8, wherein the control circuit is configured to determine the predetermined number (N21, N22) of erase or program pulses as a function of a first number of pulses (N11ᵢ, N12ᵢ) applied to first memory cells (T1) during at least one first erase or program cycle of first memory cells.

10. Nonvolatile memory according to one of claims 8 or 9, wherein the control circuit, when performing the second erase or program cycle, is configured to:
iv) apply (S24, S33) at least one erase or program pulse (Np) to the memory cells,
v) determine (S25, S34) the state, erased or programmed, of the memory cells, and
vi) repeat steps iv) and v) until the predetermined number (N21, N22) of erase or program pulses is applied to the second memory cells.

11. Nonvolatile memory according to one of claims 8 to 10, wherein the control circuit is configured to store the number of pulses (N11, N12) applied to the first memory cells to set them in the desired state, when the first erase or program cycle is performed.

12. Nonvolatile memory according to one of claims 8 to 11, wherein the control circuit is configured to determine the predetermined number (N21, N22) of erase or program pulses according to at least one of the following methods:
- the predetermined number (N21, N22) of erase or program pulses is a function of the number (N11ᵢ, N12ᵢ) of erase or program pulses applied to the first memory cells during one first erase or program cycle of first memory cells;
- the predetermined number (N21, N22) of erase or program pulses is a function of an average value of numbers (N11ᵢ, N12ᵢ) of erase or program pulses applied to the first memory cells during a plurality of first erase or program cycles of first memory cells;
- the predetermined number (N21, N22) of erase or program pulses is a function of a maximum value of numbers (N11ᵢ, N12ᵢ) of erase or program pulses applied to the first memory cells during a plurality of first erase or program cycles of first memory cells.

13. Nonvolatile memory according to one of claims 8 to 12, wherein the control circuit is configured to:
- write regular data in the first memory cells (T1) by means of the first erase or program cycle, and
- write fake data in the second memory cells (T2) by means of the second erase or program cycle.

14. Nonvolatile memory according to one of claims 8 to 13, wherein the control circuit is configured to:
- memorize addresses of second memory cells (T2), and
- only apply the second erase or program cycle to second memory cells.

15. Electronic device (ED) comprising a nonvolatile memory (MEM) according to one of claims 8 to 14.
